## Europäisches Patentamt

## European Patent Office

## Office européen des brevets

(11) Veröffentlichungsnummer: **0 004 556**
**B1**

# EUROPÄISCHE PATENTSCHRIFT

(45) Veröffentlichungstag der Patentschrift:
04.11.81

(51) Int. Cl.³: **H 01 L 21/48**, H 01 L 23/14

(21) Anmeldenummer: 79100622.4

(22) Anmeldetag: 02.03.79

(54) Verfahren und Vorrichtung zur Herstellung eines Zwischenträgers für Halbleiterchips.

(30) Priorität: 31.03.78 US 892048

(43) Veröffentlichungstag der Anmeldung:
17.10.79 Patentblatt 79/21

(45) Bekanntmachung des Hinweises auf die Patenterteilung:
04.11.81 Patentblatt 81/44

(84) Benannte Vertragsstaaten:
DE FR GB

(56) Entgegenhaltungen:
IBM TECHNICAL DISCLOSURE BULLETIN,
Band 20, Dezember 1977,
New York, USA
J. C. ARNHART et al.:
»Wire insertion and merging device«,
Seiten 2673—2674

(73) Patentinhaber: International Business Machines
Corporation, Armonk, N.Y. 10504 (US)

(72) Erfinder: Bernardo, Edward Thomas, 613 West Main
Street, Endicott New York 13760 (US)
Erfinder: Faure, Louis Henry, 24 King Drive,
Poughkeepsie New York 12603 (US)
Erfinder: Johnson, Alfred Harold, 30 Brookland Road,
Poughkeepsie New York 12601 (US)
Erfinder: Pittwood, Donald Glen, Allen Glen Road, Owego
New York 13827 (US)

(74) Vertreter: Neuland, Johannes, Dipl.-Ing., Schönaicher
Strasse 220, D-7030 Böblingen (DE)

## Verfahren und Vorrichtung zur Herstellung eines Zwischenträgers für Halbleiterchips

Die Erfindung bezieht sich auf ein Verfahren und eine Vorrichtung zur Herstellung eines Zwischenträgers für Halbleiterchips, der fächerförmig angeordnete elektrische Leiter zur Verbindung mit den Eingangs-/Ausgangsanschlüssen des Halbleiterchips aufweist.

In der Halbleitertechnologie werden die monolithisch integrierten Halbleiterschaltungen immer komplexer und immer kleiner. Mit wachsender Zahl der Schaltungen auf einem Halbleiterchip entsteht die Forderung nach mehr Eingangs-/Ausgangsanschlüssen. Mit wachsender Schaltungsdichte auf dem Halbleiterchip steht aber weniger Raum pro Eingangs-/Ausgangsanschluß des Halbleiterchips zur Verfügung. Folglich besitzen Halbleiterchips mit monolithisch integrierten Schaltungen mehr Eingangs-/Ausgangsanschlüsse von geringerer Größe. Derzeit hergestellte monolithisch integrierte Halbleiterschaltungen weisen über 100 Eingangs-/Ausgangsanschlüsse bei einer Fläche von etwa 1,5 cm² auf. Letzten Endes können bis zu 600 Eingangs-/Ausgangsanschlüsse für ein einzelnes Halbleiterchip benötigt werden.

Eine solche Dichte der Eingangs-/Ausgangsanschlüsse bietet sehr große Probleme für das Packen der Halbleiterschaltungen. Sogenannte Flip-Chip-Verbindungsverfahren besitzen das Potential zur Bildung der elektrischen Verbindung zwischen den Eingangs-/Ausgangsanschlüssen des Halbleiterchips mit den entsprechenden Anschlüssen auf den Trägerunterlagen bei großer Anschlußdichte. Jedoch bietet die Bildung von fächerförmig verlaufenden elektrischen Verbindungsleitungen zwischen den Anschlüssen auf der Trägerunterlage und den Eingangs-/Ausgangsanschlüssen der Trägerunterlage und einer diese aufnehmenden Schaltkarte Probleme. Die üblichen, auf die Flächen der Trägerunterlage zur Bildung von fächerförmig verlaufenden elektrischen Verbindungsleitungen aufgedruckten einlagigen Leiterzugsmuster können auf dem vorhandenen sehr geringen Platz nicht gebildet werden. Ein bekanntes Verfahren zur Bildung dieser erforderlichen fächerförmig verlaufenden elektrischen Verbindungsleitungen besteht in der Verwendung einer mehrere keramische Trägerunterlagen verwendenden Technologie. Bei dieser Technologie wird eine Reihe von ungebrannten Keramikblättern gebildet, in die Löcher gestanzt werden, die mit einem elektrisch leitenden Material gefüllt werden, worauf Leiterzüge auf die Keramikblätter aufgedruckt, diese aufeinandergeschichtet und gesintert werden. In dieser Weise wird das fächerförmige Leiterzugsmuster erreicht. indem es in das Substrat hineingebracht und auf verschiedenen Ebenen verteilt wird. Diese Technologie ist jedoch sehr komplex und teuer.

Ein anderes Verfahren besteht darin, eine Reihe von Metallisierungslagen auf der Oberfläche der Trägerunterlage zu bilden, wobei jeweils zwei Lagen durch eine Schicht aus einem dielektrischen Material voneinander getrennt sind. Jedoch ist dieses Verfahren begrenzt, da die Leitungen in vertikaler Richtung einen sehr geringen Abstand aufweisen. Signale der verschiedenen Leitungen werden in benachbarte Leitungen induziert und verursachen Fehler. Auch ist die Fläche auf dem Substrat, die für Eingangs-/Ausgangsstifte oder andere Verbindungselemente verfügbar ist, begrenzt.

Eine andere mögliche Lösung für das Problem der Verringerung der Anschlußdichte beim Packen integrierter Halbleiterschaltungen, das durch Halbleiterchips mit hoher Integrationsdichte hervorgerufen wird, besteht darin, einen mit dem Halbleiterchip verbundenen Zwischenträger vorzusehen, der ein eigenes Muster fächerförmig verlaufender elektrischer Verbindungsleitungen enthält. Ein Vorschlag zur Herstellung eines derartigen Zwischenträgers ist der Veröffentlichung »Wire Insertion and Merging Device« von J. C. Arnhart, L. H. Faure und A. H. Johnson im IBM Technical Disclosure Bulletin, Vol. 20, Nr. 7, Dezember 1977, Seiten 2673 und 2674 zu entnehmen. Die Erfindung bezieht sich auf diese einen Zwischenträger verwendende Lösung. Bei der Herstellung solch eines Zwischenträgers für das Aufnehmen des Halbleiterchips müssen sehr schmale Drähte genau angeordnet und während ihrer Einkapselung in ein geeignetes dielektrisches Material in dieser Stellung gehalten werden. Im Hinblick auf den sehr geringen Durchmesser der Drähte, die für die Verwendung in solchen Zwischenträgern geeignet sind, und im Hinblick auf die äußerste Präzision, die für das Anordnen der Drähte erforderlich ist, war bisher keiner Vorrichtung verfügbar, um dieses Ziel zu erreichen.

Hier will die Erfindung Abhilfe schaffen. Die Erfindung, wie sie in den Ansprüchen gekennzeichnet ist, löst die Aufgabe, ein Verfahren und eine Vorrichtung zur Herstellung eines Zwischenträgers für Halbleiterchips anzugeben, der fächerförmig verlaufende elektrische Verbindungsleitungen aufweist, die in ein dielektrisches Material eingebettet sind.

Die durch die Erfindung erzielten Vorteile sind im wesentlichen darin zu sehen, daß die Erfindung die Verwendung von Koaxialkabeln als fächerförmig verlaufende elektrische Verbindungsleitung des Zwischenträgers ermöglicht. Hierdurch wird das Übersprechen zwischen den Verbindungsleitungen stark verringert. Außerdem weisen die Verbindungsleitungen alle etwa die gleiche, kürzest mögliche Länge auf, was sich günstig auf das Einhalten eines vorgegebenen Impedanzwertes auswirkt.

Im folgenden wird die Erfindung in Verbindung mit den Zeichnungen näher erläutert. Von den Zeichnungen, die lediglich einen Ausführungsweg darstellen, zeigen:

Fig. 1 eine perspektivische Ansicht eines Teils der Vorrichtung nach der Erfindung, die einen Satz einander entsprechender Einspannelemente und eine Vorrichtung zur Verringerung des Abstandes der von den Einspannelementen gehaltenen Drähte enthält;

Fig. 2 eine Seitenansicht der Einspannelemente der erfindungsgemäßen Vorrichtung in auseinandergezogenen Zustand und der in der richtigen Lage sich befindenden Vorrichtung zum Zusammendrängen der parallelen Drähte, um den Abstand zwischen den in den Einspannelementen gehaltenen Drähten zu verringern;

Fig. 3A und 3B Vorderansichten der Vorrichtung zum Zusammendrängen der parallelen Drähte zur Verringerung des Abstandes dieser in den Einspannelementen befindlichen Drähte, wobei die Fig. 3A die Ansicht eines Schnittes wiedergibt, der längs der Linie 3A der Fig. 2 geführt wurde, die die Anordnung zum Zusammendrängen der parallelen Drähte in der Ausgangsposition zeigt, während in Fig. 3B die Vorrichtung in Arbeitsposition dargestellt ist, in der die Abstände der sich zwischen den Einspannelementen befindlichen Drähte verrringert wurden;

Fig. 4 eine Seitenansicht der Einspannelemente in auseinandergezogenem Zustand, wobei die Vorrichtung zum Zusammendrängen der parallelen Drähte in einer den Abstand dieser in den Einspannelementen gehaltenen Drähte verringernden Position dargestellt ist;

Fig. 5 eine Seitenansicht, die die Arbeitsweise der Vorrichtung zum weiteren Zusammendrängen der in den Einspannelementen befindlichen Drähte und zu ihrem Festhalten in diesem Zustand darstellt;

Fig. 6 eine Vorderansicht, die die Vorrichtung zum weiteren Zusammendrängen und Festhalten der in den Einspannelementen gehaltenen Drähte zeigt;

Fig. 7 eine teilweise geschnittene Seitenansicht der Gießform, die die zusammengedrängten und zwischen den Einspannelementen gehaltenen Drähte zeigt;

Fig. 8 ein Seitenschnitt, der das Abscheren der eingebetteten und in den Einspannelementen gehaltenen Drähte nach dem Gießen erläutert;

Fig. 9 eine Schnittvorderansicht, die den durch das Verfahren und die Vorrichtung nach der Erfindung hergestellten Zwischenträger für Halbleiterchips darstellt.

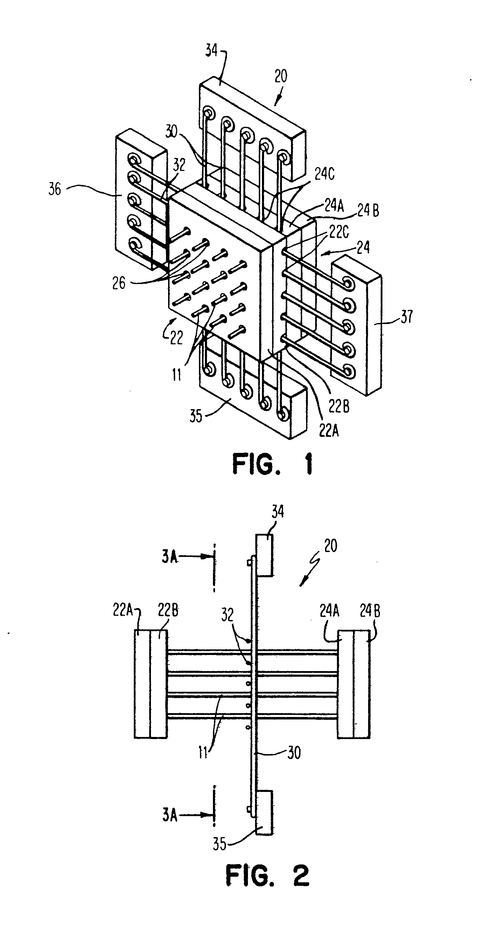

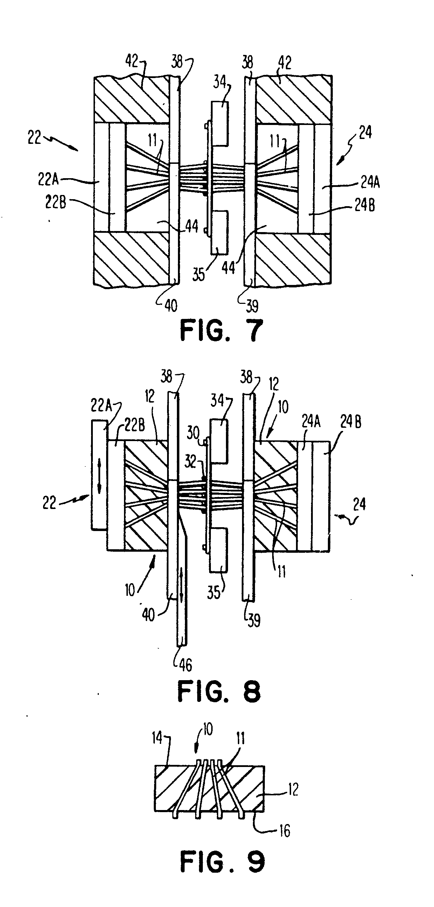

In Fig. 1 ist ein bevorzugtes Ausführungsbeispiel der Vorrichtung der Herstellung eines Zwischenträgers für Halbleiterchips dargestellt. Der Zwischenträger 10 ist in Fig. 9 dargestellt und besteht allgemein aus einer Reihe von Drähten 11, die in einem dielektrischen Material 12 eingebettet sind, vorzugsweise in einem härtbaren organischen Harzmaterial. Wie zu ersehen ist, sind die Enden der Drähte 11 auf der oberen Fläche 14 sehr dicht benachbart und dort so angeordnet, daß sie dem Anschlußmuster des darauf zu befestigenden Halbleiterchips entsprechen. Die Drähte 11 sind fächerförmig angeordnet und ragen aus der Bodenfläche 16 heraus, in der die Anordnung und der Abstand der Drahtenden einem Satz von Anschlüssen einer nicht dargestellten Montagekarte oder eines Substrates entsprechen. Die Vorrichtung 20 zur Herstellung des Zwischenträgers für Halbleiterchips besitzt ein Paar von beweglichen Einspannelementen 22 und 24, die mit einer Reihe von Öffnungen 26 versehen sind, die, wie das in Fig. 1 angedeutet ist, in Spalten und Zeilen angeordnet sind. Die Öffnungen 26 in den Einspannelementen 22 und 24 sind so ausgerichtet, daß Drähte 11 eingeführt und durch beide Einspannelemente mit Hilfe irgendeiner geeigneten, nicht dargestellten Vorrichtung gedrückt werden können. Die Anordnung und der Abstand der Löcher 26 in den Einspannelementen 22 und 24 entspricht dem aus Fig. 9 ersichtlichen Abstand der Drähte an der Unterseite des Zwischenträgers für Halbleiterchips. Die Einspannelemente 22 und 24 können in zwei komplementäre Teile 22A und B, sowie 24A und B getrennt werden, was das Abscheren der Drähte in einer späteren Verfahrensstufe ermöglicht. Zwischen den Einspannelementen 22 und 24 ist eine Vorrichtung zum Zusammendrängen der Drähte 11 vorgesehen, wodurch der Abstand dieser Drähte an einer zentralen Stelle verringert wird. Die Vorrichtung zum Zusammendrängen der Drähte besteht aus einer Reihe von vertikalen Drähten 30 und einer Reihe von horizontalen Drähten 32. Die Drähte 30 sind an ihren Enden an Querträgern 34 und 35 befestigt. Die horizontalen Drähte 32 sind drehbar mit den Querträgern 36 und 37 verbunden. Die Wirkungsweise der Einrichtung zum Zusammendrängen der Drähte wird im folgenden noch genauer beschrieben.

Auf den beiden sich gegenüberliegenden Seiten der Einspannelemente 22 und 24 sind vorzugsweise Kerben 22C und 24C zur Aufnahme der Drähte 32 und 30 vorgesehen. Wenn Kerben 22C und 24C vorgesehen sind, können die Einspannelemente 22 und 24 in enge Berührung miteinander gebracht werden, was das Einführen der Drähte 11 durch Einspannelemente hindurch erleichtert.

Die Anzahl der Öffnungen 26 in den Einspannelementen 22 und 24 kann die in Fig. 1 dargestellte Anzahl weit überschreiten. Die verhältnismäßig kleine Anzahl der dargestellten Öffnungen und Drähte reicht aus, um das Prinzip der Vorrichtung und des Verfahrens zu erläutern. Wie das deutlicher aus Fig. 2 hervorgeht, befinden sich die Drähte 32 zwischen Zeilen aus Drähten 11. Die Drähte 30 befinden sich zwischen Spalten aus Drähten 11. Die Drähte 11, die in den Zwischenträger für Halbleiterchips eingebettet werden, sind vorzugsweise isolierte Drähte, insbesondere Koaxialkabel.

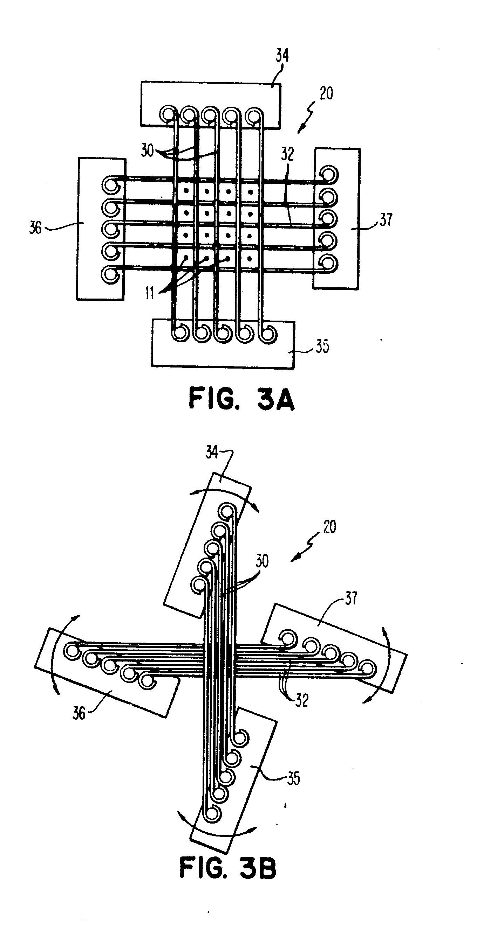

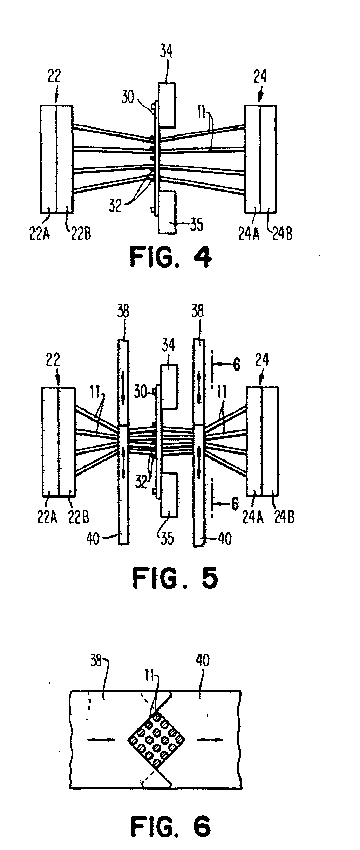

Nachdem die Drähte 11 durch die Einspannelemente 22 und 24 hindurch eingeführt wurden, werden ihre Enden in einem der Einspannelemente befestigt, beispielsweise durch leichtes Verschieben einer der beiden Hälften des Einspannelementes gegenüber der anderen und die Einspannelemente werden voneinander getrennt, wie das in Fig. 2 dargestellt ist. Die Drähte 11 gleiten durch eines der Einspannelemente, um diesen Abstand zu ermöglichen. Die Anordnung der Drähte 30 und 32 im Hinblick auf die Drähte 11 ist am klarsten in Fig. 3A dargestellt. In dieser Stufe entspricht der Abstand der Drähte 11 dem Abstand und der Lage der Löcher 26 in den Einspannelementen. Die die Drähte 30 und 32, die sich in einer Zwischenposition zwischen den Einspannelementen 22 und 24 befinden, halten den Querträger werden gedreht, wie das in Fig. 3B dargestellt ist. Beim Drehen der Querträger nimmt der Abstand zwischen den Drähten 30 und 32 gleichmäßig ab und die Drähte 11 werden dadurch zu einer Anordnung mit viel geringerem Drahtabstand zusammengedrängt, wie das in den Fig. 3B und 4 dargestellt ist. Wie aus Fig. 5 ersichtlich, drängen einander gegenüberliegende Einrichtungen 38 und 40 zum weiteren Zusammendrängen der Drähte 11 diese weiter an Punkten zusammen, die zwischen den Einspannelementen und den früher beschriebenen Einrichtungen zum Zusammendrängen der Drähte liegen. Die Drähte 11 werden durch ein Paar von Klemmbacken 38 und 40 zusammengedrängt, ohne ihre regelmäßige Anordnung in Zeilen und Spalten aufzugeben. Wie das in Fig. 6 angedeutet ist, überlappen sich die Klemmbacken auf der Seite, die den Einspannelementen gegenüberliegt, eine ebene Fläche aufweisen. Dies kann durch Vorsehen geschliffener Flächen an den Klemmbacken 38 und 40 erreicht werden, die, wenn sie aneinander anliegen, eine ebne Fläche bieten. Zusätzlich zu dem Durchführen des Zusammendrängens der Drähte 11 dienen die Klemmbacken 38 und 40 auch als Teil der Gießform, die benutzt wird, um die Drähte 11 einzubetten.

Wie das in Fig. 7 dargestellt ist, wird eine Gießform in eine Stellung relativ zu den Matrizen 22 und 24 und den Klemmbacken 38 und 40 gebracht, um einen Formhohlraum 44 zu definieren. Ein dielektrisches Material wird dann in den Formhohlraum 44 gepreßt, wo es aushärtet und dadurch die Drähte 11 einkapselt. Nach dem Aushärten des dielektrischen Materials werden die Enden der Drähte 11, wie das in Fig. 8 dargestellt ist, durch Bewegen der Teile 22A und 24A relativ zu den Teilen 22B und 24B der Einspannelemente bewegt. Die Drähte auf der anderen Seite des Zwischenträgers für Halbleiterchips werden mit einem Messer 46 abgeschert.

Nach dem Entfernen des Zwischenträgers für Halbleiterchips aus der Gießform wird die Isolation der Drähte 11, die etwas aus dem Zwischenträger für Halbleiterchips hervorragen, entfernt. Dies kann zweckmäßigerweise dadurch erreicht werden, daß man die Drähte einem geeigneten Lösungsmittel aussetzt, das das isolierende Material auflöst.

## Patentansprüche

1. Verfahren zur Herstellung eines Zwischenträgers für Halbleiterchips, der fächerförmig angeordnete elektrische Leiter zur Verbindung mit den Eingangs-/Ausgangsanschlüssen des Halbleiterchips aufweist, gekennzeichnet durch folgende Verfahrensschritte:

a) Einspannen einer Reihe elektrisch isolierter Drähte (11; Fig. 1) in den matrixartig angeordneten Öffnungen (26) zweier flacher Einspannelemente (22, 24),

b) Zusammendrängen der elektrisch isolierten Drähte an wenigstens einer zwischen den Einspannelementen gelegenen Stelle derart, daß ihr gegenseitiger Abstand sich bis zu dieser Stelle in zwei zueinander senkrechten Richtungen gleichmäßig verringert,

c) Bilden wenigstens einer Gießform (42; Fig. 7) um die eingespannten und zusammengedrängten elektrisch isolierten Drähte, als deren Wände auch das Einspannelement (z. B. 22) und eine die elektrisch isolierten Drähte weiter zusammendrängende und in diesem Zustand festhaltende Vorrichtung (38, 40) dienen,

d) Einspritzen eines härtbaren organischen Harzmaterials in die Gießform zum Einkapseln der darin befindlichen elektrisch isolierten Drähte und

e) Abscheren der Drähte hinter den Gießformwandungen und Herausnehmen des Zwischenträgers aus der Gießform.

2. Verfahren nach Anspruch 1, dadurch gekennzeichnet, daß als elektrisch isolierte Drähte Koaxialkabel verwendet werden.

3. Verfahren nach den Ansprüchen 1 und 2, dadurch gekennzeichnet, daß zur Herstellung von jeweils zwei Zwischenträgern die eingespannten elektrisch isolierten Drähte an zwei zwischen den Einspannelementen liegenden Stellen in zusammengedrängter Lage festgehalten werden und zwei Gießformen zum Einspritzen eines härtbaren organischen Harzmaterials gebildet werden.

4. Verfahren nach den Ansprüchen 1 bis 3, dadurch gekennzeichnet, daß das Zusammendrängen der eingespannten elektrisch isolierten Drähte bis zum gegenseitigen Berühren durch in zwei dicht benachbarten parallelen Ebenen, die sich senkrecht zur Längsachse der eingespannten elektrisch isolierten Drähte vor deren Zusammendrängen erstrecken, angeordnete Drähte erfolgt, deren gegenseitiger Abstand verringert wird und von denen die Drähte in der ersten Ebene senkrecht zu denen in der zweiten Ebene verlaufen.

5. Vorrichtung zur Durchführung des Verfahrens nach den Ansprüchen 1 bis 4, gekennzeichnet durch

a) ein Paar von Einspannelementen (22, 24; Fig. 4) mit ebenen, einander gegenüberliegender Flächen, wobei jedes Einspannelement matrixartig angeordnete Löcher (26; Fig. 1), die mit den Löchern des anderen Einspannelementes ausgerichtet sind, zum Aufnehmen elektrisch isolierter Drähte (11) aufweist,

b) einen ersten Satz von zwischen den Einspannelementen waagerecht und parallel zueinander sowie in einer Ebene senkrecht zur Längsachse der elektrisch isolierten Drähte angeordneten Drähten (30),

c) einen zweiten Satz von Drähten (32), die ebenfalls parallel zueinander in einer Ebene angeordnet sind, die der Ebene des ersten Satzes unmittelbar benachbart ist, in ihr jedoch senkrecht zur Richtung der Drähte des ersten Satzes verlaufen,

d) eine Vorrichtung (34, 35, 36, 37; Fig. 3) zur Verringerung des Abstandes der Drähte des ersten und zweiten Satzes und dadurch des gegenseitigen Abstandes der matrixartig angeordneten elektrisch isolierten Drähte,

e) eine Vorrichtung zum Einandernähern der Einspannelemente und zum Einbringen der elektrisch isolierten Drähte in die matrixartig angeordneten Löcher der Einspannelemente sowie zum anschließenden Voneinanderwegbewegen der Einspannelemente,

f) eine zwischen den Einspannelementen und der Vorrichtung nach d) angeordnete Vorrichtung (30, 40) zum weiteren Zusammendrängen und Festhalten der matrixartig angeordneten elektrisch isolierten Drähte,

g) eine zurückziehbare Gießform (42; Fig. 7), die die elektrisch isolierten Drähte zwischen einem Einspannelement und der Vorrichtung zum weiteren Zusammendrängen und Festhalten der matrixartig angeordneten elektrisch isolierten Drähte umgibt,

h) eine Vorrichtung zum Einbringen eines härtbaren organischen Harzmaterials in die Gießform und

i) eine Vorrichtung (46; Fig. 8) zum Abschneiden der elektrisch isolierten Drähte unmittelbar hinter der eine Wand der Gießform bildenden Vorrichtung zum weiteren Zusammendrängen und Festhalten der matrixartig angeordneten elektrisch isolierten Drähte.

6. Anordnung nach Anspruch 5, dadurch gekennzeichnet, daß jedes der Einspannelemente auf der dem anderen Einspannelement zugewandten Fläche einen Satz parallel verlaufender Kerben (22C, 24C; Fig. 1) aufweist zur Aufnahme der beiden Drahtsätze nach b) und c) des Anspruchs 5, welche Kerben das Aneinanderliegen der beiden ebenen, sich gegenüberliegenden Flächen der beiden Einspannelemente beim Einbringen der elektrisch isolierten Drähte in die matrixartig angeordneten Löcher ermöglichen.

7. Anordnung nach den Ansprüchen 5 und 6, dadurch gekennzeichnet, daß die Vorrichtung zum weiteren Zusammendrängen und Festhalten der matrixartig angeordneten elektrisch isolierten Drähte ein Paar einander gegenüberliegender Klemmbacken aufweist, deren die Drähte berührende Flächen unter 45° zur Bewegungsrichtung der Klemmbacken verlaufen.

8. Anordnung nach den Ansprüchen 5 bis 7, dadurch gekennzeichnet, daß die Vorrichtung zur Verringerung des Abstandes der Drähte des ersten und zweiten Satzes ein Querträgerpaar (34, 35; 36, 37; Fig. 3) für jeden Drahtsatz aufweist, an dem die Drähte drehbar befestigt sind, und daß die Querträger selbst zur Verringerung des Drahtabstandes ebenfalls drehbar angeordnet sind.

9. Anordnung nach den Ansprüchen 5 bis 8, dadurch gekennzeichnet, daß jedes Einspannelement aus zwei mit matrixartig angeordneten Löchern versehenen hintereinanderliegenden Platten (22A, 22B; 24A, 24B; Fig. 4) zusammengesetzt ist.

10. Anordnung nach den Ansprüchen 5 bis 9, dadurch gekennzeichnet, daß eine erste Vorrichtung vorgesehen ist, die die beiden Platten eines Einspannelementes zum Abscheren der eingespannten und in das Kunstharz eingebetteten elektrisch isolierten Drähte gegeneinander bewegt und daß eine zweite Vorrichtung vorgesehen ist, die ein Abschermesser (46; Fig. 8) über die rückseitige Fläche der Klemmbacken der Vorrichtung zum weiteren Zusammendrängen und Festhalten der matrixartig angeordneten elektrisch isolierten Drähte bewegt, um die Drähte abzuscheren.

### Claims

1. A method of fabricating a semiconductor chip mounting element comprising fan-out electric conductors for connection to the semiconductor chip input/output terminals, characterized by the following method steps:

a) engaging a plurality of electrically insulated wires (11; Fig. 1) in the apertures (26) arranged in columns and rows of two flat die elements (22, 24),

b) compating said electrically insulated wires at least at one location between said die elements in such a manner that their spacing up to said location is uniformly reduced in two orthogonal directions,

c) forming at least one mold (42; Fig. 7) enclosing said engaged and compacted electrically insulated wires, one of said die elements (e. g., 22) and a means (38, 40) compacting said electrically insulated wires further and maintaining them in that state also serving as walls of said mold,

d) injecting an organic hardenable resin material into said mold, thereby encapsulating the electrically insulated wires positioned therein, and

e) shearing said wires adjacent said mold walls and removing said mounting element from said mold.

2. The method according to claim 1, characterized in that said insulated wires are coaxial cables.

3. The method according to claims 1 and 2, characterized in that for fabricating two of said mounting elements, said engaged electrically insulated wires are maintained in a compacted position at two locations lying between said die elements, and two molds are formed for injecting an organic hardenable resin material.

4. The method according to claims 1 to 3, characterized in that compacting of said engaged electrically insulated wires until they contact one another is effected by wires arranged in two closely adjacent parallel planes extending perpendicularly to the longitudinal axis of said engaged electrically insulated wires prior to their compression, the spacing of said wires arranged in two closely adjacent parallel planes being reduced and the wires in the first plane extending perpendicularly to the wires in the second plane.

5. An apparatus for implementing the method according to claims 1 to 4, characterized by

a) a pair of die elements (22, 24; Fig. 4) with facing flat surfaces, each die element being provided with apertures arranged in columns and rows (26; Fig. 1), which are aligned to the apertures of the other die element for accommodating electrically insulated wires (11),

b) a first set of wires (30) located between said die elements and positioned horizontally and parallel to each other and in a plane extending perpendicularly to said longitudinal axis of said electrically insulated wires,

c) a second set of wires (32) also extending parallel to each other in a plane immediately adjacent to that of said first set but extending in said plane perpendicularly to the wires of said first set,

d) a means (34, 35, 36, 37; Fig. 3) for reducing the spacing of the wires of said first and said second set and thus the spacing of said electrically insulated wires arranged in columns and rows,

e) a means for moving said die elements into a closely spaced relationship and for introducing said electrically insulated wires into said die element apertures arranged in columns and rows and for subsequently moving said die elements into a widely spaced relationship,

f) a means (30, 40) arranged between said die elements and said means according to d) for compacting further and maintaining the column and row orientation of said electrically insulated wires,

g) a retractable mold (42; Fig. 7) surrounding said electrically insulated wires between a die element and said means for compacting further and maintaining said column and row orientation of said electrically insulated wires,

h) a means for introducing an organic hardenable resin material into said mold, and

i) a means (46; Fig. 8) for shearing said electrically insulated wires immediately adjacent said means forming one wall of said mold for compacting further and maintaining said column and row orientation of said electrically insulated wires.

6. The apparatus according to claim 5, characterized in that each of said die elements has a set of parallel grooves (22C, 24C; Fig. 1) on the surface facing the other die element for accommodating said two wire sets according to b) and c) of claim 5, said grooves permitting abutting of said facing surfaces of said two die elements during the loading of said electrically insulated wires into said apertures arranged in columns and rows.

7. The apparatus according to claims 5 and 6, characterized in that said means for compacting further and maintaining said column and row orientation of said electrically insulated wires is comprised of a pair of opposed jaws provided with wire engaging surfaces positioned at 45° relative to the path of movement of said jaws.

8. The apparatus according to claims 5 to 7, characterized in that said means for reducing the spacing of the wires of said first and said second set is comprised of a cross bar pair (34, 35; 36, 37; Fig. 3) for each of said wire sets, to which said wires are pivotally attached, and that said cross bars proper are also pivotally arranged for reducing said wire spacing.

9. The apparatus according to claims 5 to 8, characterized in that each of said die elements is comprised of two plates (22A, 22B; 24A, 24B; Fig. 4) arranged in series and provided with apertures arranged in columns and rows.

10. The apparatus according to claims 5 to 9, characterized in that a first means is provided to move said two plates of a die element relative to each other for shearing said engaged and resin encapsulated electrically insulated wires, and that a second means is provided moving a shearing blade (46; Fig. 8) over the rear face of said jaws of said means for compacting further and maintaining said column and row orientation of said electrically insulated wires for shearing.

**Revendications**

1. Procédé pour fabriquer un support intermédiaire pour des microplaquettes semi-conductrices munies de conducteurs électriques disposés en éventail, pour la connexion avec les bornes d'entrée et de sortie de la microplaquette semi-conductrice, caractérisé en ce qu'il comporte les étapes suivantes:

a) insertion d'un certain nombre de fils électriquement isolés (11; figure 1) dans les ouvertures (26) de deux éléments de matrice plats (22, 24), les ouvertures étant disposées sous forme de matrice de rangées et de colonnes,

b) regroupement des fils électriquement isolés au moins à un emplacement situé entre les éléments de matrice, de sorte que l'espacement mutuel de ces fils diminue uniformément jusqu'à cet emplacement dans deux directions orthogonales l'une par rapport à l'autre,

c) fabrication d'au moins un moule (42; figure 7) autour des fils électriquement isolés, insérés dans les matrices et regroupés, l'un des éléments de matrice (par exemple 22) et un dispositif (38, 40), permettant de regrouper encore plus les fils électriquement isolés et de les maintenir dans cet état, servant de parois pour ledit moule,

d) injection d'un matériau de résine organique durcissable dans le moule pour enrober les fils électriquement isolés qu'il contient, et

e) sectionnement des fils derrière les parois du moule et enlèvement du support intermédiaire du moule.

2. Procédé selon la revendication 1, caractérisé en ce que les fils isolés électriquement sont des câbles coaxiaux.

3. Procédé selon l'une quelconque des revendications 1 et 2, caractérisé en ce que pour la réalisation de deux des supports intermédiaires on maintient, les fils électriquement isolés regroupés en deux emplacements situés entre les éléments de matrice et en ce que l'on forme deux moules pour l'injection d'un matériau de résine organique durcissable.

4. Procédé selon l'une quelconque des revendications 1 à 3, caractérisé en ce que les fils électriquement isolés sont regroupés, jusqu'à entrer en contact mutuel, par des fils disposés dans deux plans parallèles très voisins s'étendant perpendiculairement par rapport à l'axe longitudinal des fils électriquement isolés, et ce, avant le regroupement de ceux-ci, l'espacement desdits fils disposés dans deux plans parallèles très voisins étant diminué et les fils dans le premier plan s'étendant perpendiculairement par rapport à ceux du second plan.

5. Dispositif pour réaliser le procédé défini selon l'une quelconque des revendications 1 à 4, caractérisé en ce qu'il comprend:

a) une paire d'éléments de matrice (22, 24; figures 4) ayant des surfaces planes qui se font faces, chaque élément de matrice étant muni d'ouvertures (26; figure 1) disposées sous forme de matrices, de rangées et de colonnes, alignées avec les ouvertures des autres éléments de matrice et destinées à recevoir les fils électriquement isolés (11),

b) un premier jeu de fils (30) situé entre les éléments de matrice et disposés horizontalement et parallèlement les uns par rapport aux autres et dans un plan perpendiculaire à l'axe longitudinal des fils électriquement isolés,

c) un second jeu de fils (32) également disposé parallèlement les uns par rapport aux autres dans un plan adjacent au plan du premier jeu, mais s'étendant dans ce plan perpendiculairement à la direction des fils du premier jeu,

d) un dispositif (34, 35, 36, 37; figure 3) pour diminuer l'espacement des fils des premier et second jeux et par là, l'espacement mutuel des fils électriquement isolés disposés en matrice,

e) un dispositif pour rapprocher les éléments de matrice et pour insérer les fils électriquement isolés dans les ouvertures, disposées en rangées et colonnes, des éléments de matrice, et pour écarter ensuite les éléments de matrice,

f) un dispositif (30, 40) disposé entre les éléments de matrice et le dispositif selon d) pour regrouper encore plus les fils électriquement isolés, et les maintenir dans leur disposition en rangées et en colonnes,

g) un moule rétractable (42; figure 7) entourant les fils électriquement isolés entre un élément de matrice et le dispositif pour regrouper encore plus les fils électriquement isolés et les maintenir dans leur disposition en rangées et en colonnes,

h) un dispositif pour injecter un matériau de résine organique durcissable dans le moule, et

i) un dispositif (46; figure 8) pour sectionner les fils électriquement isolés immédiatement derrière le dispositif formant une paroi du moule.

6. Dispositif selon la revendication 5, caractérisé en ce que chaque élément de matrice est muni sur la surface faisant face à l'autre élément de serrage d'un jeu d'encoches parallèles (22C, 24C; figure 1) pour recevoir les deux jeux de fils tels que définis en b) et c) dans la revendication 5, lesdites encoches permettant aux deux surfaces plates se faisant faces des deux éléments de matrice d'être adjacentes lors de l'insertion des fils électriquement isolés dans les ouvertures disposées en matrices.

7. Dispositif selon l'une quelconque des revendications 5 et 6, caractérisé en ce que le dispositif pour regrouper et maintenir les fils électriquement isolés disposés en matrices est muni d'une paire de mâchoires se faisant faces dont les surfaces en contact avec les fils sont placées selon un angle de 45° par rapport au sens du mouvement des machoires.

8. Dispositif selon l'une quelconque des revendications 5 à 7, caractérisé en ce que le dispositif pour diminuer l'espacement des fils des premier et second jeux est muni d'une paire de traverses (34, 35; 36, 37; figure 3) pour chaque jeu de fils, à laquelle les fils sont fixés de façon pivotable, et en ce que les traverses mêmes sont disposées également de façon pivotable, pour pouvoir diminuer l'espacement de fils.

9. Dispositif selon l'une quelconque des revendications 5 à 8, caractérisé en ce que chaque élément de matrice est composé de deux plaques (22A, 22B; 24A, 24B; figure 4) placées l'une après l'autre et munies d'ouvertures disposées en matrices.

10. Dispositif selon l'une quelconque des revendications 5 à 9, caractérisé en ce qu'il est prévu un premier dispositif qui déplace les deux plaques d'un élément de matrice l'une par rapport à l'autre pour sectionner les fils électriquement isolés, tendus et enrobés dans la résine synthétique et en ce qu'il est prévu un second dispositif qui déplace un couteau de sectionnement (46; figure 8) le long de la face arrière des mâchoires du dispositif pour regrouper et maintenir les fils électriquement isolés disposés en matrices dans le but de sectionner les fils.

FIG. 1

FIG. 2

FIG. 3A

FIG. 3B

FIG. 4

FIG. 5

FIG. 6

13

FIG. 7

FIG. 8

FIG. 9

15